# EUROPEAN PATENT SPECIFICATION

(11) **EP 2 486 453 B1**
(45) Date of publication and mention of the grant of the patent: **29.01.2014**
(21) Application number: 09764035.3
(22) Date of filing: 12.11.2009
(51) Int. Cl.: G03F 7/09

(54) **POSITIVE-WORKING PHOTOIMAGEABLE BOTTOM ANTIREFLECTIVE COATING**
POSITIV ARBEITENDE FOTOABBILDBARE ANTIREFLEX-UNTERBESCHICHTUNG
REVÊTEMENT DE FOND ANTI-REFLETS PHOTO-IMAGEABLE FONCTIONNANT EN POSITIF

(30) Priority: 09.10.2009 US 576622
(43) Date of publication of application: 15.08.2012
(73) Proprietor: AZ Electronic Materials USA Corp., Somerville, New Jersey 08876 (US)
(72) Inventor: DAMMEL, Ralph, R., Min Buri, Bangkok 10510 (TH); CHAKRAPANI, Srinivasan, Bridgewater, NJ 08807 (US); PADMANABAN, Munirathna, Bridgewater, NJ 08807 (US); MIYAZAKI, Shinji, Shizuoka pref. 437-0042 (JP); NG, Edward, W., Belle Mead, NJ 08502 (US); KUDO, Takanori, Bedminster, NJ 07921 (US); DIOSES, Alberto, D., Doylestown, PA 18902 (US); HOULIHAN, Francis, M., Millington, NJ 07946 (US)
(74) Representative: Féaux de Lacroix, Stefan
(86) International application number: PCT/IB2009/007456
(87) International publication number: WO 2011/042770

(56) References cited:
- WO-A-2005/093513
- US-A1- 2005 255 410
- US-A1- 2009 104 559

## Description

### Field of Invention

The present invention relates to novel positive-working, photoimageable, and aqueous developable antireflective coating compositions and their use in image processing by forming a thin layer of the novel antireflective coating composition between a reflective substrate and a photoresist coating. Such compositions are particularly useful in the fabrication of semiconductor devices by photolithographic techniques, especially those requiring exposure with deep ultraviolet radiation. These coatings are particularly compatible for use with an edge bead remover.

### Description

Photoresist compositions are used in microlithography processes for making miniaturized electronic components such as in the fabrication of computer chips and integrated circuits. Generally, in these processes, a thin coating of a film of a photoresist composition is first applied to a substrate material, such as silicon wafers used for making integrated circuits. The coated substrate is then baked to evaporate any solvent in the photoresist composition and to fix the coating onto the substrate. The baked and coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the photoresist.

There are two types of photoresist compositions, negative-working and positive-working. When positive-working photoresist compositions are exposed image-wise to radiation, the areas of the photoresist composition exposed to the radiation become soluble in a developer solution while the unexposed areas of the photoresist coating remain relatively insoluble to such a solution. Thus, treatment of an exposed positive-working photoresist with a developer causes removal of the exposed areas of the photoresist coating and the formation of a positive image in the coating, thereby uncovering a desired portion of the underlying substrate surface on which the photoresist composition was deposited. In a negative-working photoresist the developer removes the portions that are not exposed.

The trend towards the miniaturization of semiconductor devices has led both to the use of new photoresists that are sensitive to lower and lower wavelengths of radiation, and also to the use of sophisticated multilevel systems to overcome difficulties associated with such miniaturization.

High resolution, chemically amplified, deep ultraviolet (100-300 nm) positive and negative tone photoresists are available for patterning images with less than quarter micron geometries. There are two major deep ultraviolet (uv) exposure technologies that have provided significant advancement in miniaturization, and these are lasers that emit radiation at 248 nm and 193 nm. Examples of such photoresists are given in the following patents and incorporated herein by reference, US 4,491,628, US 5,350,660, EP 794458 and GB 2320718. Photoresists for 248 nm have typically been based on substituted polyhydroxystyrene and its copolymers. On the other hand, photoresists for 193 nm exposure require non-aromatic polymers, since aromatics are opaque at this wavelength. Generally, alicyclic hydrocarbons are incorporated into the polymer to replace the etch resistance lost by eliminating the aromatic functionality. Furthermore, at lower wavelengths the reflection from the substrate becomes increasingly detrimental to the lithographic performance of the photoresist. Therefore, at these wavelengths antireflective coatings become critical.

Positive-working antireflective coating compositions containing vinyl+ether-terminated crosslinking agents are known from WO2005/093513, US2009/0104559 and US2005/0255410.

The use of highly absorbing antireflective coatings in photolithography is a simpler approach to diminish the problems that result from back reflection of light from highly reflective substrates. The bottom antireflective coating is applied on the substrate and then a layer of photoresist is applied on top of the antireflective coating. The photoresist is exposed imagewise and developed. The antireflective coating in the exposed area is then typically etched and the photoresist pattern is thus transferred to the substrate. Most antireflective coatings known in the prior art are designed to be dry etched. The etch rate of the antireflective film needs to be relatively high in comparison to the photoresist so that the antireflective film is etched without excessive loss of the resist film during the etch process. There are two known types of antireflective coatings, inorganic coatings and organic coatings. However, both of these types of coatings have so far been designed for removal by dry etching.

In addition, photoresist patterns may be damaged or may not be transferred exactly to the substrate if the dry etch rate of the antireflective coating is similar to or less than the etch rate of the photoresist coated on top of the antireflective coating. The etching conditions for removing the organic coatings can also damage the substrate. Antireflective coating compositions that must be removed by dry etching are known. Thus, there is a need for organic bottom antireflective coatings that do not need to be dry etched and can also provide good lithographic performance, especially for compound semiconductor type substrates, which are sensitive to etch damage.

The novel approach of the present application is to use an absorbing, positive image-forming bottom antireflective coating that can be developed by an aqueous alkaline solution, rather than be removed by dry etching. Aqueous removal of the bottom antireflective coating eliminates the dry etch rate requirement of the coating, reduces the cost intensive dry etching processing steps and also prevents damage to the substrate caused by dry etching. The absorbing bottom antireflective coating compositions of the present invention contain a crosslinking compound and a polymer. The coating is cured and then upon exposure to light of the same wavelength as that used to expose the top positive photoresist become imageable in the same developer as that used to develop the photoresist. This process greatly simplifies the lithographic process by eliminating a large number of processing steps. Since the antireflective coating is photosensitive, the extent of removal of the antireflective coating is defined by the latent optical image, which allows a good delineation of the remaining photoresist image in the antireflective coating.

The novel antireflective composition of the present invention relates to a photoimageable, aqueous alkali developable, positive-working antireflective coating. The antireflective coating composition of the instant invention is coated on a substrate before applying a photoresist layer, in order to prevent reflections in the photoresist from the substrate. The solid components of the antireflective coating are soluble in common photoresist solvents and capable of forming a coating, and furthermore are compatible with edge-bead remover solvents. Edge-bead remover solvents are used to remove the build-up on the edges of the antireflective coating formed during the spin coating process. This antireflective coating is photoimageable at the same wavelength of actinic radiation as the top photoresist layer applied thereupon, and is also developable with the same aqueous alkaline developing solution as that used for typically developing a photoresist. The combination of single exposure step and single development step greatly simplifies the lithographic process. Furthermore, an aqueous developable antireflective coating is especially desirable for imaging with photoresists that do not contain aromatic functionalities, such as those used for 193 nm and 157 nm exposures. The novel composition enables a good image transfer from the photoresist to the substrate, and also has good absorption characteristics to prevent reflective notching and line width variations or standing waves in the photoresist. Additionally, substantially no intermixing is present between the antireflective coating and the photoresist film. The antireflective coatings also have good solution stability and form thin films with good coating quality, the latter being particularly advantageous for lithography. When the antireflective coating is used with a photoresist in the imaging process, clean images are obtained, without damaging the substrate.

### Summary of the Invention

The present invention relates to a positive bottom photoimageable antireflective coating composition as claimed in claim 1.

Embodiments thereof are described in claims 2-9. The invention further relates to a process for imaging as claimed in claim 10 using the antireflective composition of the present invention. Embodiments of the process are defined in claims 11, 12.

### Detailed Description of the Invention

The present invention relates to a novel absorbing, photoimageable and aqueous developable positive image-forming antireflective coating composition comprising a polymer comprising at least one unit with a crosslinking group such as hydroxyl and/or carboxyl group and at least one unit with an absorbing chromophore, a vinyl ether terminated crosslinking agent, and optionally, a photoacid generator. A thermal acid generator may also be present in the composition. The polymer may or may not be alkali-soluble and water insoluble. The invention further relates to a process for using such a composition, especially for irradiation from 50 nm to 450nm, to which the photoacid generator is preferably sensitive.

The antireflective coating composition of the invention is coated on a substrate and below a positive photoresist, in order to prevent reflections in the photoresist from the substrate. This antireflective coating is photoimageable with the same wavelength of light as the top photoresist, and is also developable with the same aqueous alkaline developing solution as that used to typically develop the photoresist, thus forming a pattern in the antireflective coating. The antireflective coating composition comprises a polymer, a crosslinking agent and, optionally, a photoacid generator. The antireflective coating composition is coated on a reflective substrate. The edge bead which may form during the spinning process can then be removed using an edgebead removing solvent, since the polymer is still soluble in solvents used as edgebead removers. The coating is then baked to remove the solvent of the coating solution and also to crosslink the coating, in order to prevent, or minimize, the extent of intermixing between the layers and make the coating insoluble in the aqueous alkaline developer. Although not being bound by theory, it is believed that during the baking step a reaction takes place between the crosslinking agent, especially compounds containing vinyl ether terminal groups, and the polymer with the hydroxyl and/or a carboxyl group in the antireflective coating, to form acid labile groups within the coating. After baking and curing the antireflective coating is essentially insoluble in both an alkaline developing solution and the solvent of the photoresist.

A positive photoresist is then coated on top of the cured antireflective coating and baked to remove the photoresist solvent. The coating thickness of the photoresist is generally greater than the underlying antireflective coating. Prior to exposure to actinic radiation both the photoresist and the antireflective coating are insoluble in the aqueous alkaline developing solution of the photoresist. The bilevel system is then imagewise exposed to radiation in one single step, where an acid is then generated in both the top photoresist and the bottom antireflective coating. If a photoacid generator is present in the antireflective coating it is photolysed. When a photoacid generator is not present in the antireflective coating, the acid may diffuse from the photoresist into the antireflective coating. In a subsequent baking step, in the exposed regions the polymer of the antireflective coating with the crosslinked sites (acid labile groups), are decrosslinked in the presence of the photogenerated acid, thus making the polymer and hence the antireflective coating soluble in the aqueous alkaline developer. A subsequent developing step then dissolves the exposed regions of both the positive photoresist and the antireflective coating, thus producing a positive image, and leaving the substrate clear for further processing.

The novel antireflective coating that is useful for the novel process of this invention comprises a crosslinking agent, a polymer, and optionally, a photoacid generator. The polymer comprises at least one unit with a crosslinking group such as hydroxyl and/or a carboxyl group and at least one unit with an absorbing chromophore. The absorbing chromophore is bound within the polymer chain, as opposed to being a free dye in the composition, in order to avoid decomposition or sublimation of the free dye during the process of baking the coating.

The polymer of the antireflective coating of the invention contains at least one unit with hydroxyl and/or carboxyl group and at least one unit with an absorbing chromophore. Examples of an absorbing chromophore are hydrocarbon aromatic moieties and heterocyclic aromatic moieties with from one to four separate or fused rings, where there are 3 to 10 atoms in each ring. Examples of monomers with absorbing chromophores that can be polymerized with the monomers containing hydroxyl or carboxyl groups are vinyl compounds containing substituted and unsubstituted phenyl, substituted and unsubstituted anthracyl, substituted and unsubstituted phenanthryl, substituted and unsubstituted naphthyl, substituted and unsubstituted heterocyclic rings containing heteroatoms such as oxygen, nitrogen, sulfur, or combinations thereof, such as pyrrolidinyl, pyranyl, piperidinyl, acridinyl, quinolinyl. The substituents may be any hydrocarbyl group and may further contain heteroatoms, such as, oxygen, nitrogen, sulfur or combinations thereof. Examples of such groups are (C₁-C₁₂) alkylene, esters, ethers, etc. Other chromophores are described in US 6,114,085, and in US 5,652,297, US 5,981,145, US 6,187,506, US 5,939,236, and US 5,935,760, which may also be used. The preferred chromophoric monomers are vinyl compounds of substituted and unsubstituted phenyl, substituted and unsubstituted anthracyl, and substituted and unsubstituted naphthyl; and more preferred monomers are styrene, hydroxystyrene, acetoxystyrene, vinyl benzoate, vinyl 4-tert-butylbenzoate, ethylene glycol phenyl ether acrylate, phenoxypropyl acrylate, N-methyl maleimide, 2-(4-benzoyl-3-hydroxyphenoxy)ethyl acrylate, 2-hydroxy-3-phenoxypropyl acrylate, phenyl methacrylate, benzyl methacrylate, 9-anthracenylmethyl methacrylate, 9-vinylanthracene, 2-vinylnaphthalene, N-vinylphthalimide, N-(3-hydroxy)phenyl methacrylamide, N-(3-hydroxy-4-hydroxycarbonylphenylazo)phenyl methacrylamide, N-(3-hydroxyl-4-ethoxycarbonylphenylazo)phenyl methacrylamide, N-(2,4-dinitrophenylaminophenyl) maleimide, 3-(4-acetoaminophenyl)azo-4-hydroxystyrene, 3-(4-ethoxycarbonylphenyl)azo-acetoacetoxy ethyl methacrylate, 3-(4-hydroxyphenyl)azo-acetoacetoxy ethyl methacrylate, tetrahydroammonium sulfate salt of 3-(4-sulfophenyl)azoacetoacetoxy ethyl methacrylate and equivalent structures. It is within the scope of this invention that any chromophore that absorbs at the appropriate exposure wavelength may be used alone or in combination with other chromophores.

The polymer of the novel invention comprises at least one unit with a hydroxyl and/or a carboxyl group to provide alkaline solubility, and a crosslinking site. One function of the polymer is to provide a good coating quality and another is to enable the antireflective coating to change solubility during the imaging process. The hydroxyl or carboxyl groups in the polymer provide one of the components necessary for the solubility change. Examples of monomers which provide such a unit upon polymerization are without limitations, substituted or unsubstituted vinyl monomers containing a hydroxyl and or carboxyl group, such as acrylic acid, methacrylic acid, vinyl alcohol, hydroxystyrenes, vinyl monomers containing 1,1',2,2',3,3'-hexafluoro-2-propanol, although any monomer that makes the polymer alkali soluble and preferably water insoluble, may be used. The polymer may contain a mixture of monomer units containing hydroxyl and/or carboxyl groups. Vinyl monomers containing the 1,1,1,3,3,3-hexafluoro-2-propanol group are exemplified with the compounds represented by structures (1) to (6) and their substituted equivalents.

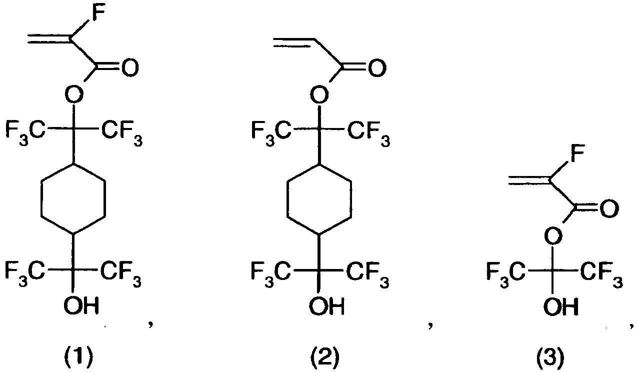

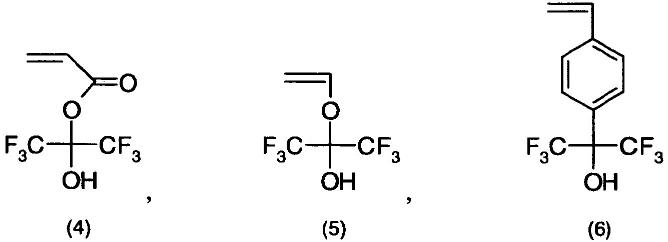

Thus a polymer may be synthesized by polymerizing monomers that contain a hydroxyl or carboxyl group with monomers that contain an absorbing chromophore. Alternatively, the alkali soluble polymer may be reacted with compounds that provide the hydroxyl or carboxyl group and compounds that provide the absorbing chromophore. In the final polymer the mole % of the unit or units containing the hydroxyl or carboxyl group can range from 5 to 95, preferably 10 to 90, and more preferably 20 to 80 and the mole % of the absorbing chromophore unit in the final polymer can range from 5 to 95, preferably 10 to 90 more preferably 20 to 80. It is also within the scope of this invention that the hydroxyl or carboxyl group is attached to the absorbing chromophore or that the chromophore is attached to the hydroxyl or carboxyl group, that is, both groups are present in the same unit. As an example the chromophoric groups described previously may have pendant hydroxyl and/or carboxyl groups or that the chromophoric groups and the hydroxyl group and/or carbonyl group are attached to the same group. Polymers such as those described in US application number 12/570,923 filed September 30, 2009 may also be used. Mixtures of nonmiscible polymers may be used, for example, one of the polymers comprises fluorinated groups.

Other than the unit containing the hydroxyl and/or carboxyl group and the unit containing the absorbing chromophore, the polymer may contain other monomeric units, such units may provide other desirable properties. Examples of the third monomer are -CR₁R₂-CR₃R₄-, where R₁ to R₄ are independently H, (C₁-C₁₀) alkyl, (C₁-C₁₀) alkoxy, nitro, halide, cyano, alkylaryl, alkenyl, dicyanovinyl, SO₂CF₃, COOZ, SO₃Z, COZ, OZ, NZ₂, SZ, SO₂Z, NHCOZ, SO₂NZ₂, where Z is H, or (C₁-C₁₀) alkyl, hydroxy (C₁-C₁₀) alkyl, (C₁-C₁₀) alkylOCOCH₂COCH₃, or R₂ and R₄ combine to form a cyclic group such as anhydride, pyridine, or pyrollidone, or R₁ to R₃ are independently H, (C₁-C₁₀) alkyl, (C₁-C₁₀) alkoxy and R₄ is a hydrophilic group. Examples of the hydrophilic group, are given here but are not limited to these: O(CH₂)₂OH, O(CH₂)₂O(CH₂)OH, (CH₂)ₙOH (where n=0-4), COO(C₁-C₄) alkyl, COOX and SO₃X (where X is H, ammonium, alkyl ammonium. Other monomers may be methyl methacrylate, butyl methacrylate, hydroxyethyl methacrylate and hydroxypropyl methacrylate. Monomeric units containing acid labile groups are also used, such as hydroxystyrene, vinyl alcohol, (meth)acrylic acid capped with acid labile groups. Examples of acid labile groups, without limitation, are secondary and tertiary alkyls (up to 20 carbon atoms) with at least one β hydrogen, acetals and ketals, trimethylsilyl, and β- trimethylsilyl substituted alkyls. Representative examples of acid labile groups are tert-butyl, tert-pentyl, isobornyl, 1-alkylcyclohexyl, 1-alkylcyclopentyl, cyclohexyl, 2-alkyl-2-adamantyl, 2-alkyl-2-norbornyl. Other examples of acid labile groups are tetrahydrofuranyl, tetrahydropyranyl, substituted or unsubstituted methoxycarbonyl, β-trialkylsilylalkyl groups (e.g. CH₂-CH₂Si(CH₃)₃, CH(-CH₂Si(CH₃)₃)₂, CH₂-CH(Si(CH₃)₃)₂ and the like.

Novolak resins can also be used as suitable polymers for antireflective coatings. These resins are typically produced by conducting a condensation reaction between formaldehyde and one or more multi-substituted phenols, in the presence of an acid catalyst, such as oxalic acid, maleic acid, or maleic anhydride. Typical monomers may be formaldehyde, cresols, resorcinols, xylenols, etc.

Examples of polymers are novolaks, polyhydroxystyrenes, and copolymers of hydroxystyrene, where the other comonomers are at least one of styrene, vinyl alcohol, acrylic acid, methacrylic acid, acrylic esters, methacrylic esters, etc.

The polymers of this invention may be synthesized using any known method of polymerization, such as ring-opening metathesis, free-radical polymerization, condensation polymerization, using metal organic catalysts, or anionic or cationic copolymerization techniques. The polymer may be synthesized using solution, emulsion, bulk, suspension polymerization, or the like. The polymers of this invention are polymerized to give a polymer with a weight average molecular weight from 1,000 to 1,000,000, preferably from 2,000 to 80,000, more preferably from 6,000 to 50,000. The polydispersity(Mw/Mn) of the free-radical polymers, where Mw is the weight average molecular weight and Mn is the number average molecular weight, can range from 1.0 to 10.0, where the molecular weights of the polymer may be determined by gel permeation chromatography.

The novel antireflective coating composition is coated and then cured on the substrate by the application of heat. Heating induces a crosslinking reaction between the carboxyl group or hydroxyl group on the polymer and the crosslinking agent, and the acid labile crosslinkages are formed. A particular acid labile acetal crosslinkage can easily be facilitated when the crosslinking agent is a vinyl ether terminated compound and the polymer contains a carboxyl group or hydroxyl group. The resulting structure is highly solvent-resistant and impervious to the interdiffusion of photoresist components. Such curing processes are the same as those of the normal thermosetting antireflective coatings.

The vinyl ether terminated crosslinking agents that are used in the instant invention are selected from tris(2-vinyloxyethyl)-1,3,5-cyclohexanetricarboxylate; tris(2-vinyloxybutyl)-1,3,5-cyclohexanetricarboxylate; tris(4-vinyloxybutyl)-1,2,4-cyclohexanetricarboxylate; tris(4-vinyloxyethyt)-1,2,4-cyclohexanetricarboxylate. Vinyl ether crosslinking agents are represented by structures (8) and (9). Some of the alicyclic vinylether compounds can be obtained by hydrogenation of the corresponding aromatic compounds like the trimellitic acid derivatives.

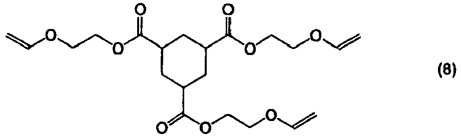

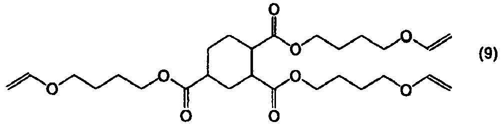

The vinyl ether terminated crosslinking agent is preferably added to the antireflective coating in a proportion which provides 0.20-2.00 mol equivalents of vinyl ether crosslinking function per reactive group on the polymer, especially preferred is 0.50 -1.50 reactive equivalents per reactive group.

In one embodiment where the antireflective coating composition comprises a photoacid generator, the photoacid generator in the antireflective coating and the photoacid generator in the photoresist, are sensitive to the same wavelength of light, and thus the same radiant wavelength of light can cause an acid to be formed in both layers. The acid in the exposed areas of the antireflective coating, present either through diffusion from the photoresist or through photogeneration from the photoacid generator in the antireflective film, reacts with the acid labile crosslinkages to decrosslink the polymer, thus making the exposed areas of the antireflective coating soluble in the aqueous alkaline developer. The photoacid generator of the antireflective coating chosen depends on the photoresist to be used. The photoacid generator (PAG) of the novel composition is selected from those which absorb at the desired exposure wavelength, preferably 248 nm, 193 nm and 157 nm for deep ultraviolet photoresists, and naphthoquinone diazides or sulfonium salts for 365 nm, 436 nm and broadband photoresists. Suitable examples of the acid generating photosensitive compounds include, without limitation, ionic photoacid generators (PAG), such as diazonium salts, iodonium salts, sulfonium salts, or non-ionic PAGs such as diazosulfonyl compounds, sulfonyloxy imides, and nitrobenzyl sulfonate esters, although any photosensitive compound that produces an acid upon irradiation may be used. The onium salts are usually used in a form soluble in organic solvents, mostly as iodonium or sulfonium salts, examples of which are diphenyliodonium trifluoromethane sulfonate, diphenyliodonium nonafluorobutane sulfonate, triphenylsulfonium trifluromethane sulfonate, triphenylsulfonium nonafluorobutane sulfonate and the like. Other compounds that form an acid upon irradiation that may be used, are triazines, oxazoles, oxadiazoles, thiazoles, substituted 2-pyrones. Phenolic sulfonic esters, bis-sulfonylmethanes, bis-sulfonylmethanes or bis-sulfonyldiazomethanes, triphenylsulfonium tris(trifluoromethylsulfonyl)methide, triphenylsulfonium bis(trifluoromethylsulfonyl)imide, diphenyliodonium tris(trifluoromethylsulfonyl)methide, diphenyliodonium bis(trifluoromethylsulfonyl)imide and their homologues are also possible candidates. Mixtures of photoactive compounds may also be used. Other types of photoacid generators may be included in the novel composition, such as those described in US application number 12/269,072 filed November 12, 2008, and may be illustrated by one or more photoactive compounds having the formula, W'-(L-(G))ₚ, where W' is PAG or Q, where PAG is a photoacid generator and Q is a quencher; each L is a direct bond or a linking group; each G is independently G1 or G2; G1 is OH; G2 is OCH9CH₂; p is 1 to 12. Some embodiments include those where p is from 2 to 6 as well as when there is a mixture of G1 and G2 on the same compound; for example (G1-L)ₚ₁-W-(L-G2)ₚ₂ where p1 and p2 are each greater than or equal to 1 and p1 + p2 equal 2 to 12.

For exposure at 365 nm the photoacid generator can be sulfonium salts or diazonaphthoquinones, especially 2,1,4-diazonaphthoquinones that are capable of producing acids that can react with the acid labile groups of the polymer. Oxime sulfonates, substituted or unsubstituted naphthalimidyl triflates or sulfonates are also known as photoacid generators. Any photoacid generator that absorbs light at the same wavelength as the top photoresist may be used. Photoacid generators known in the art may be used, such as those disclosed in the US 5,731,386, US 5,880,169, US 5,939,236, US 5,354,643, US 5,716,756.

The solvent for the antireflective coating is chosen such that it can dissolve all the solid components of the antireflective coating. Examples of suitable solvents for the antireflective coating composition are cyclohexanone, cyclopentanone, anisole, 2-heptanone, ethyl lactate, propylene glycol monomethyl ether acetate, propylene glycol monomethyl ether, butyl acetate, gamma butyroacetate, ethyl cellosolve acetate, methyl cellosolve acetate, methyl 3-methoxypropionate, ethyl pyruvate, 2-methoxybutyl acetate, diacetone alcohol, diethyl carbonate, 2-methoxyethyl ether, but ethyl lactate, propylene glycol monomethyl ether acetate, propylene glycol monomethyl ether or mixtures thereof are preferred. Solvents with a lower degree of toxicity and good coating and solubility properties are generally preferred.

The composition of the present invention may further comprise an acid or a thermal acid generator. Crosslinking can take place between a polymer containing a hydroxyl and/or carboxyl group and a crosslinking agent in the presence of heat, however, typically reaction times may be long. Thermal acid generators or acids are used to accelerate the crosslinking reaction and are desirable for instances where short curing times are preferred. Thermal acid generators liberate the acid upon heating. Any known acids or thermal acid generators may be used, exemplified without limitations, by 2,4,4,6-tetrabromocyclohexadienone, benzoin tosylate, squaric acid, 2-nitrobenzyl tosylate, chloroacetic acid, toluenesulfonic acid, methanesulfonic acid, nonaflate acid, triflic acid, other alkyl esters of organic sulfonic acids, salts of these mentioned acids. However, it has been found that for certain components some acids and acids produced by thermal acid generators, which have high acidity, can lead to undercutting and can prevent the desired photoimaging process from taking place. Thus, it has been unexpectedly found that acids with moderate acidity, i.e. with a pKa (-log₁₀ of the acid dissociation constant) greater than 1.0 are preferred, especially in combination with a vinyl terminated crosslinking agent. Acids with a pKa of less than 5.0 and greater than 1.0 are also preferred. The resulting acetal linkages are easily cleavable in the presence of photogenerated acids. Examples, without limitations, of acids or acids derived from thermal acid generators with moderate acidity are maleic acid (pKa of 1.83), chloroacetic acid (pKa of 1.4), dichloroacetic acid (pKa of 1.48), oxalic acid (pKa of 1.3), cinnamic acid (pKa of 4.45), tartaric acid (pKa of 4.3), gylcolic acid (pKa of 3.8), fumaric acid (pKa of 4.45), malonic acid (pKa of 2.8), cyanoacetic acid (pKa of 2.7), etc. Acids which are blocked by bases to form a thermal acid generator are preferred. Acids, such as those described above, may be blocked with bases such as amines. Typical bases are triethyl amine, tripropyl amine, trimethyl amine, tributyl amine, tripentyl amine, tridodecyl amine etc. Additionally, diaryl or trialkyl sulfonium salts with anions of weak acids, such as carboxylic acid or aryl carboxylic acid may be used. Acids which are blocked by bases may be formed by combining the acid with a base, where the acid:base ratio ranges from 1:1 to 1:3. Further examples of acids with the desired pKa and their salts can be found by one of ordinary skill in the art by reviewing the available literature, such as in CRC Handbook of Chemistry and Physics, published by CRC Press Inc. and incorporated herein by reference. In some embodiments it may also be desirable that the thermal acid be such that once the acid is generated it does not remain permanently in the coating and therefore does not facilitate the reverse reaction, but is removed from the film. It is believed that, once crosslinking takes place the acid is decomposed or volatilized by heat and the decomposition products are baked out of the film, or the acid may sublime from the coating. Thus none or very little of the free acid remains in the film after curing, and the reverse reaction causing the decomposition of the acetal linkage does not take place. Thermal acid generators which can generate an acid and then be removed prior to coating of the photoresist are preferred in some cases. Weak acids that remain in the film may also be functional, as they may not greatly hinder the decomposition of the acetal linkage. The acid or acid derived from the thermal acid generator is preferably removed from the antireflective coating at temperatures ranging from about 130°C to about 220°C, more preferably 150°C to about 200°C. The acids or thermal acid generators may be present in the antireflective composition at levels ranging from 0.1 to 25 weight% of solids, especially 0.1 to about 5 weight%.

Typical antireflective coating compositions of the present invention may comprise up to 15 percent by weight of the solids, preferably less than 8 percent, based on the total weight of the coating composition. The solids may comprise from 0 to 25 weight percent of the photoacid generator, 50 to 99 weight percent of polymer, 1 to 50 weight percent of the crosslinking agent and optionally 0 to 25 weight percent of the acid or thermal acid generator, based on the total solids content of the antireflective coating composition. Preferably the photoacid generator level ranges from 0.01 to 20 weight%. Preferably the crosslinking agent ranges from 5 to 40 weight percent, more preferably 10 to 35 weight percent. The solid components are dissolved in the solvent, or mixtures of solvents, and filtered to remove impurities. The components of the antireflective coating may also be treated by techniques such as passing through an ion exchange column, filtration, and extraction process, to improve the quality of the product.

Other components may be added to the antireflective composition of the present application in order to enhance the performance of the coating, e.g. lower alcohols, dyes, surface leveling agents, adhesion promoters, antifoaming agents, etc. These additives may be present at up to 30 weight percent level. Other polymers, such as, novolaks, polyhydroxystyrene, polymethylmethacrylate and polyarylates, may be added to the composition, providing the performance is not negatively impacted. Preferably the amount of this polymer is kept below 50 weight % of the total solids of the composition, more preferably 35 weight %, and even more preferably below 20 weight %. Bases may also be added to the composition to enhance stability. Both photobases and nonphotobases are known additives. Examples of bases are amines, ammonium hydroxide, and photosensitive bases. Particularly preferred bases are tetrabutylammonium hydroxide, triethanolamine, diethanol amine, trioctylamine, n-octylamine, trimethylsulfonium hydroxide, triphenylsulfonium hydroxide, bis(t-butylphenyl)iodonium cyclamate and tris(tert-butylphenyl)sulfonium cyclamate.

The absorption parameter (k) of the novel composition ranges from 0.1 to 1.0, preferably from 0.15 to 0.7 as measured using ellipsometry. The refractive index (n) of the antireflective coating is also optimized. The n and k values can be calculated using an ellipsometer, such as the J. A. Woollam WVASE VU-302 TM Ellipsometer. The exact values of the optimum ranges for k and n are dependent on the exposure wavelength used and the type of application. Typically for 193 nm the preferred range for k is 0.1 to 0.75, for 248 nm the preferred range for k is 0.15 to 0.8, and for 365 nm the preferred range is from 0.1 to 0.8. The thickness of the antireflective coating is less than the thickness of the top photoresist. Preferably the film thickness of the antireflective coating is less than the value of (wavelength of exposure/refractive index), and more preferably it is less than the value of (wavelength of exposure/2 times refractive index), where the refractive index is that of the antireflective coating and can be measured with an ellipsometer. The optimum film thickness of the antireflective coating is determined by the exposure wavelength, refractive indices of the antireflective coating and of the photoresist, absorption characteristics of the top and bottom coatings, and optical characteristics of the substrate. Since the bottom antireflective coating must be removed by exposure and development steps, the optimum film thickness is determined by avoiding the optical nodes where no light absorption is present in the antireflective coating.

The antireflective coating composition is coated on the substrate using techniques well known to those skilled in the art, such as dipping, spin coating or spraying. Various substrates known in the art may be used, such as those that are planar, have topography or have holes. Examples of semiconductor substrates are crystalline and polycrystalline silicon, silicon dioxide, silicon (oxy)nitride, aluminum, aluminum/silicon alloys, and tungsten. In certain cases there can be a buildup of photoresist film at the edges of the substrate, referred to as edge bead. This edge bead can be removed using a solvent or mixture of solvents using techniques well known to those of ordinary skill in the art. The composition of the present invention is particularly compatible with edge bead removers. Typical solvents used for edge bead removers are ethyl lactate, butyl acetate, propyleneglycol monomethyletheracetate, propyleneglycol monomethylether, or mixtures thereof. The coating is then cured. The preferred range of temperature is from 120°C to 240°C for 30-120 seconds on a hot plate or equivalent heating unit, more preferably from 150°C to 200°C for 45-90 seconds. The film thickness of the antireflective coating ranges from 20 nm to 300 nm. The optimum film thickness is determined, as is well known in the art, to be where good lithographic properties are obtained, especially where no standing waves are observed in the photoresist. It has been unexpectedly found that for this novel composition very thin coatings can be used due to the excellent absorption and refractive index properties of the film. The cured antireflective coating is also insoluble at this stage in the alkaline developing solution. The photoresist can then be coated on top of the antireflective coating.

Positive photoresists, which are developed with aqueous alkaline solutions, are useful for the present invention, provided the photoactive compounds in the photoresist and the antireflective coating absorb at the same exposure wavelength used for the imaging process for the photoresist. Positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the formation of a positive image in the photoresist coating. Photoresist resolution is defined as the smallest feature which the resist composition can transfer from the photomask to the substrate with a high degree of image edge acuity after exposure and development. In many manufacturing applications today, resist resolution on the order of less than one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate. This becomes even more critical as the drive toward miniaturization reduces the critical dimensions on the devices.

Positive-acting photoresists comprising novolak resins and quinone-diazide compounds as photoactive compounds are well known in the art. Novolak resins are typically produced by condensing formaldehyde and one or more multi-substituted phenols, in the presence of an acid catalyst, such as oxalic acid. Photoactive compounds are generally obtained by reacting multihydroxyphenolic compounds with naphthoquinone diazide acids or their derivatives. The sensitivity of these types of resists typically ranges from 300 nm to 440 nm.
Photoresists sensitive to short wavelengths, between 180 nm and 300 nm can also be used. These photoresists normally comprise polyhydroxystyrene or substituted polyhydroxystyrene derivatives, a photoactive compound, and optionally a solubility inhibitor. The following references exemplify the types of photoresists used US 4,491,628, US 5,069,997 and US 5,350,660. Particularly preferred for 193 nm and 157 nm exposure are photoresists comprising non-aromatic polymers, a photoacid generator, optionally a solubility inhibitor, and solvent. Photoresists sensitive at 193 nm that are known in the prior art are described in the following references and incorporated herein, US 6,447,980 and US 6,723,488, although any photoresist sensitive at 193 nm may be used on top of the antireflective composition of this invention.

A film of photoresist is then coated on top of the cured antireflective coating and baked to substantially remove the photoresist solvent. The photoresist and the antireflective coating bilevel layers are then imagewise exposed to actinic radiation. In a subsequent heating step the acid generated during exposure step reacts to de-crosslink the polymer of the antireflective coating composition and thus rendering the exposed region of the antireflective coating alkali soluble in the developing solution. The temperature for the postexposure bake step can range from 40°C to 200°C for 30-200 seconds on a hot plate or equivalent heating system, preferably from 80°C to 160°C for 40-90 seconds. In some instances, it is possible to avoid the postexposure bake, since for certain chemistries, such as some acetal acid labile linkages, deprotection proceeds at room temperature. The polymer in the exposed regions of the antireflective coating is now soluble in an aqueous alkaline solution. The bilevel system is then developed in an aqueous alkaline developer to remove the photoresist and the antireflective coating. The developer is preferably an aqueous alkaline solution comprising, for example, tetramethyl ammonium hydroxide. The developer may further comprise additives, such as surfactants, polymers, isopropanol, ethanol, etc. The process of coating and imaging photoresist coatings and antireflective coatings is well known to those skilled in the art and is optimized for the specific type of photoresist and antireflective coating combination used. The imaged bilevel system can then be processed further as required by the manufacturing process of integrated circuits, for example metal deposition and etching.

Each of the documents referred to above are incorporated herein by reference in its entirety, for all purposes. The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

### Examples

The absorption parameter (k) and the refractive index (n) were measured using variable angle spectrophotometric ellipsometry. The bottom antireflective coating (B.A.R.C.) solutions were spin coated on primed silicon wafers and baked to get a given film thickness. The coated wafers were then measured using an ellipsometer manufactured by J.A. Woollam or Sopra Corporation. The obtained data were fitted to get the k and n values of the B.A.R.C. films.

### Synthesis Example 1

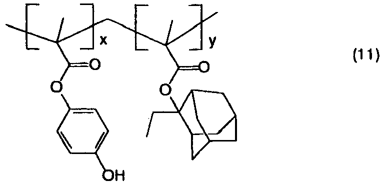

In a 250 mL flask equipped with a reflux condenser, a thermometer, under nitrogen, 4-hydroxyphenyl methacrylate (8.71 g), 1-ethyl-1-adamantyl methacrylate (12.14 g), 2,2'-azobisisobutyronitrile (AIBN) (1.04 g), and tetrahydrofuran (128 g) were purged with nitrogen and heated to reflux for 5 hours. The polymerization was capped with methanol (3 g), and then precipitated into hexanes (1.05 L). The precipitated polymer was redissolved in tetrahydrofuran(THF) (70 g), and precipitated in hexanes (1.05 L) once again. The precipitated solid was dissolved in methanol (70 g) and precipitated in water (1.05 L). The precipitated solid was dried in an oven at 45°C for 48 hours to give a white solid (10.8 g, 49.5 %). This material was found to have a weight average molecular weight (Mw) of 8,454 and a number average molecular weight (Mn) of 4,822 by gel permeation (GPC) chromatography. The polymer had n&k values at 193nm of 1.80 & 0.57.

### Synthesis Example 2

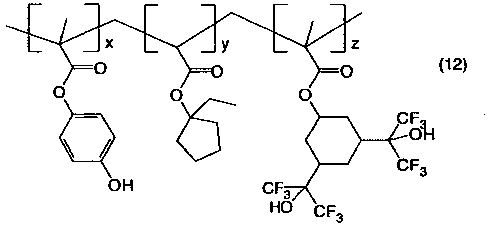

In a 250 mL flask equipped with a reflux condenser, a thermometer, under nitrogen, 4-hydroxyphenyl methacrylate (23.18 g), 1-ethyl-1-cyclopentyl acrylate (7.29 g), bis-3,5-(2-hydroxyhexafluoro-2-propyl)-cyclohexyl methacrylate (3,5-MA-3,5-HFA-CHOH) (21.71 g), AIBN (7.83 g), and tetrahydrofuran (140 g) were purged with nitrogen and heated to reflux for 5 hours. The polymerization was capped with methanol (6 mL), and then precipitated into hexanes (1.4 L). The precipitated polymer was redissolved in tetrahydrofuran (140 g), and precipitated in hexanes (1.4 L) once again. The precipitated solid was dissolved in methanol (160 g) and precipitated in water (1.4 L). The precipitated solid was dried in an oven at 45°C for 48 hours to give a white solid (44.5 g, 85.2 %). This material was found to have a Mw of 18,080 and a Mn of 9,575 by gel permeation (GPC) chromatography. The polymer had n&k values at 193nm of 1.73 & 0.54.

### Synthesis Example 3

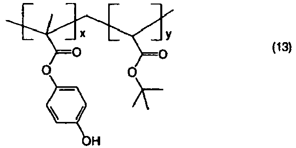

In a suitable container fitted with a mechanical stirrer, addition funnel, and nitrogen source, 4-hydroxyphenylmethacrylate 16.86g (94.6 mmol) and tert-butylacrylate 8.09g (63.1 mmol) were dissolved in 66g THF. The mixture was stirred under nitrogen at room temperature for 20 minutes, and then heated to 70°C. 2,2'-azobisisobutyronitrile (AIBN) 5.05g (30.8 mmol) in 4g THF was added to the reaction mixture. The reaction mixture was stirred for additional 5 hours at 70°C. The reaction mixture was then cooled down to room temperature, diluted with additional 70 ml THF, and then added to a mixture of 300 ml butylacetate and 700 ml heptane mixture, causing a precipitate to form. The precipitate was filtered, added to 1000 ml heptane, filtered again, and then dried at 40°C in a vacuum oven (95% yield). This material was found to have an Mw of 19,236 and a Mn of 8,920 by gel permeation (GPC) chromatography. The polymer had n&k values at 193nm of 1.67 & 0.51.

### Synthesis Example 4

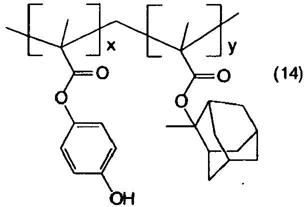

In a 250 mL flask equipped with a reflux condenser, a thermometer, under nitrogen, 4-hydroxyphenyl methacrylate (12.2 g), 1-methyl-1-adamantyl methacrylate (13.9 g), AIBN (3.9 g), and tetrahydrofuran (70 g) were purged with nitrogen and heated to reflux for 5 hours. The polymerization was capped with methanol (3 mL), then precipitated into hexanes (750 mL). The precipitated polymer was redissolved in tetrahydrofuran (90 g), and precipitated in hexanes (750 mL) once again. The precipitated solid was dissolved in methanol (80 g) and precipitated in water (750 mL). The precipitated solid was dried in an oven at 45°C for 48 hours to give a white solid (24.6 g, 94.2 %). This material was found to have an Mw of 13,914 and a Mn of 4,974 by gel permeation (GPC) chromatography. The polymer had n&k values at 193nm of 1.77 & 0.45.

### Example 5

The co-polymer from Synthesis Example 1 (0.21 g), tris(vinyloxyethyl) 1,3,5-cyclohexanetricarboxylate (0.06g), triethylammonium malonate-triethylamine (0.03g) and bis(triphenylsulfonium) perfluorobutanedisulfonate (0.05g) were dissolved in 24.1 g propyleneglycol monomethylether to form a photosensitive antireflective composition. The B.A.R.C. solution was filtered through a 0.2µm microfilter.

The B.A.R.C. solution was coated on a primed silicon wafer and heated on a hotplate at 190°C for 60 seconds to give a film thickness of 400 Å. The B.A.R.C. wafer was coated with AZ® AX 2110P photoresist (available from AZ® Electronic Materials USA Corp., Somerville, NJ), heated on a hotplate for 100°C for 60 seconds to give a film thickness of 210 nm. The coated wafer was exposed using a Nikon 306D 193 nm scanner for imagewise exposure. The exposed wafer was then post exposure baked for 60 seconds at 110°C and followed with a 30-second puddle development at 23 °C using of AZ® 300 MIF Developer. Using a secondary electron microscope, 100 nm photoresist/B.A.R.C. trenches (1:1) were obtained with clean pattern for photoresist and clean trench spaces with complete opening of the B.A.R.C. layer at a dose of 25 mJ/cm².

### Example 6

The co-polymer from Synthesis Example 2 (0.21 g), tris(vinyloxybutyl) 1,2,4-cyclohexanetricarboxylate (0.06 g), triethylammonium malonate-triethylamine (0.03 g) and bis(triphenylsulfonium) perfluorobutanedisulfonate (0.002 g) were dissolved in propyleneglycol monomethylether (24.7 g) to form a photosensitive antireflective composition. The B.A.R.C. solution was filtered through a 0.2µm microfilter.

The B.A.R.C. solution was coated on a primed silicon wafer and heated on a hotplate at 190°C for 60 seconds to give a film thickness of 400 Å. The B.A.R.C. wafer was coated with AZ® AX 2110P photoresist (available from AZ Electronic Materials USA Corp., Somerville, NJ), heated on a hotplate for 100°C for 60 seconds to give a film thickness of 210 nm. The coated wafer was exposed using an Nikon 306D 193 nm scanner for imagewise exposure. The exposed wafer was then post exposure baked for 60 seconds at 110°C and followed with a 30-second puddle development at 23 °C using of AZ® 300 MIF Developer. Using a secondary electron microscope, 100 nm photoresist/B.A.R.C. trenches (1:1) were obtained with clean pattern for photoresist and clean trench spaces with complete opening of the B.A.R.C. layer at a dose of 29 mJ/cm².

### Example 7

The polymer from Synthesis Example 4 (0.25 g), tris(vinyloxybutyl) 1,2,4-cyclohexanetricarboxylate (0.06 g), triethylammonium malonate-triethylamine (0.04 g) and bis(triphenylsulfonium) perfluorobutanedisulfonate (0.003 g) were dissolved in propyleneglycol monomethylether (26.4 g) to form a photosensitive antireflective composition. The B.A.R.C. solution was filtered through a 0.2µm microfilter.

The B.A.R.C. solution was coated on a primed silicon wafer and heated on a hotplate at 190°C for 60 seconds to give a film thickness of 400 Å. The B.A.R.C. wafer was coated with AZ® AX 2110P photoresist (available from AZ Electronic Materials USA Corp., Somerville, NJ), heated on a hotplate for 100°C for 60 seconds to give a film thickness of 210 nm. The coated wafer was exposed using an Nikon 306D 193 nm scanner for imagewise exposure. The exposed wafer was then post exposure baked for 60 seconds at 110°C and followed with a 30-second puddle development at 23 °C using of AZ® 300 MIF Developer. Using a secondary electron microscope, 90 nm photoresist/B.A.R.C. trenches (1:1) were obtained with clean pattern for photoresist and clean trench spaces with complete opening B.A.R.C. layer at a dose of 29 mJ/cm².

### Example 8

0.234 g of polymer from Example 3, 0.0186 g of triethylamine, 0.0234 g of bis bis(4-hydroxyphenyl)phenylsulfonium 1,4-perfluorobutanedisulfonate, 0.0276 g of triethylamonium malonate, and 0.0562 g of tris(4-vinyloxybutyl)-1,2,4-cyclohexanetricarboxylate were dissolved in 26.166 g of propylene glycol monomethyl ether. The B.A.R.C. solution was filtered through 0.2 µm microfilter.

The B.A.R.C. solution was coated on a primed silicon wafer and heated on a hotplate at 120°C for 60 seconds to give a film thickness of 396 Å. The B.A.R.C. wafer was coated with AZ® AX 2110P photoresist (available from AZ Electronic Materials USA Corp., Somerville, NJ), heated on a hotplate for 100°C for 60 seconds to give a film thickness of 210 nm. The coated wafer was exposed using an Nikon 306D 193 nm scanner for imagewise exposure. The exposed wafer was then post exposure baked for 60 seconds at 110°C and followed with a 30-second puddle development at 23 °C using of AZ® 300 MIF Developer. Using a secondary electron microscope, 125 nm photoresist/B.A.R.C. trenches (1:1) were obtained with clean pattern for photoresist and clean trench spaces with complete opening B.A.R.C. layer at a dose of 42 mJ/cm².

### Comparative Example 9

0.234 g of polymer from Example 3, 0.0185 g of triethylamine, 0.0234 g of bis(4-hydroxyphenyl)phenylsulfonium 1,4-perfluorobutanedisulfonate, 0.0279 g of triethylamonium malonate, and 0.0562 g of tris(4-vinyloxy butyl) trimellitate (0.2g, Vectomer®5015, available from Aldrich Co.), were dissolved in 26.166 g of propylene glycol monomethyl ether. The B.A.R.C. solution was filtered through 0.2 µm microfilter.

The B.A.R.C. solution was coated on a primed silicon wafer and heated on a hotplate at 120°C for 60 seconds to give a film thickness of 395 Å. The B.A.R.C. wafer was coated with AZ® AX 2110P photoresist (available from AZ Electronic Materials USA Corp., Somerville, NJ), heated on a hotplate for 100°C for 60 seconds to give a film thickness of 210 nm. The coated wafer was exposed using a Nikon 306D 193 nm scanner for imagewise exposure. The exposed wafer was then post exposure baked for 60 seconds at 110°C and followed with a 30-second puddle development at 23 °C using of AZ® 300 MIF Developer. Using a secondary electron microscope, 125 nm photoresist/B.A.R.C. trenches (1:1) were obtained with scum at the foot of the pattern & incomplete opening of the trench spaces of B.A.R.C. layer at a dose of 42 mJ/cm².

## Claims

1. A positive bottom photoimageable antireflective coating composition which is capable of being developed in an aqueous alkaline developer, wherein the antireflective coating composition comprises a polymer comprising at least one chromophore group, at least one acid labile group and at least one hydroxyl and/or a carboxyl group, a vinyl ether terminated crosslinking agent and optionally, a photoacid generator; wherein the vinyl ether terminated crosslinking agent is selected from tris(2-vinyloxybutyl)-1,3,5-cyclohexanetricarboxylate, tris(2-vinyloxyethyl)-1,3,5-cyclohexanetricarboxylate, tris(4-vinyloxybutyl)-1,2,4-cyclohexanetricarboxylate and tris(4-vinyloxyethyl)-1,2,4-cyclohexanetricarboxylate.

2. The composition according to claim 1, wherein the chromophore group is chemically bonded to the polymer and is selected from a compound containing aromatic hydrocarbon rings, a substituted or unsubstituted phenyl group, a substituted or unsubstituted anthracyl group, a substituted or unsubstituted phenanthryl group, a substituted or unsubstituted naphthyl group, a substituted or an unsubstituted heterocyclic aromatic rings containing heteroatoms selected from oxygen, nitrogen, sulfur, and a mixture thereof.

3. The composition according to claim 1 or 2, wherein the recurring unit containing a hydroxyl and/or a carboxyl group is derived from a monomer selected from acrylic acid, methacrylic acid, vinyl alcohol, hydroxystyrenes, copolymers of hydroxystyrene and vinyl monomers containing 1,1,1,3,3,3-hexafluoro-2-propanol.

4. The composition according to any one of claims 1 to 3, wherein the chromophore group and the hydroxyl and/or a carboxyl group are present in the same recurring unit.

5. The composition according to any one of claims 1 to 4 wherein the vinyl ether terminated crosslinking agent is tris(2-vinyloxyethyl)-1,3,5-cyclohexanetricarboxylate.

6. The composition of any one of claims 1 to 5, further comprising an acid or a thermal acid generator, where preferably the acid or the acid derived from the thermal acid generator has a pKa greater than 1.0 and where preferably the acid or the acid derived from the thermal acid generator is removed from the antireflective coating at temperatures below 220°C.

7. The composition according to any one of claims 1 to 6 further comprising a dye, which preferably is selected from the group consisting of a monomeric dye, a polymeric dye and a mixture of a monomeric and a polymeric dye.

8. The composition according to any one of claims 1 to 7, wherein the antireflective composition has a k value in the range of 0.1 to 0.75 at 193 nm.

9. The composition according to any one of claims 1 to 8, wherein the polymer further comprises an acid labile group, which preferably is selected from tert-butyl, tert-pentyl, isobornyl, 1-alkylcyclohexyl,1-alkylcyclopentyl, cyclohexyl, 2-alkyl-2-adamantyl, 2-alkyl-2-norbornyl,tetrahydrofuranyl, tetrahydropyranyl, substituted or unsubstitutedmethoxycarbonyl and b-trialkylsilylalkyl.

10. A process for forming a positive image comprising:
a) forming a coating of the bottom photoimageable antireflective coating composition of any one of claims 1 to 9 on a substrate;
b) baking the antireflective coating,
c) providing a coating of a top photoresist layer over the bottom coating;
d) imagewise exposing the photoresist and bottom coating layers to actinic radiation of same wavelength;
e) post-exposure baking the photoresist and bottom coating layers on the substrate; and,
f) developing the photoresist and bottom coating layers with an aqueous alkaline solution.

11. The process according to claim 10, further comprising the step of removal of an edgebead after the coating and prior to the baking of the antireflective coating composition.

12. The process according to claim 10 or 11, wherein the antireflective coating becomes insoluble in organic solvents and aqueous alkaline solution after the baking step prior to coating the photoresist layer and becomes soluble in aqueous alkaline solution after exposure to actinic radiation prior to developing the photoresist and bottom antireflective coating layer.

## Patentansprüche

1. Positive photoabbildbare Antireflexunterbeschichtungszusammensetzung, die dazu geeignet ist, in einem wässrigen alkalischen Entwickler entwickelt zu werden, wobei die Antireflexbeschichtungszusammensetzung ein Polymer, umfassend mindestens eine chromophore Gruppe, mindestens eine säurelabile Gruppe und mindestens eine Hydroxyl- und/oder eine Carboxylgruppe, ein vinyletherterminiertes Verzweigungsreagenz und gegebenenfalls einen Photosäuregenerator umfasst; wobei das vinyletherterminierte Verzweigungsreagenz ausgewählt ist aus Tris(2-vinyloxybutyl)-1,3,5-cyclohexantricarboxylat, Tris(2-vinyloxyethyl)-1,3,5-cyclohexantricarboxylat, Tris(4-vinyloxybutyl)-1,2,4-cyclohexantricarboxylat und Tris(4-vinyloxyethyl)-1,2,4-cyclohexantricarboxylat.

2. Zusammensetzung gemäß Anspruch 1, wobei die chromophore Gruppe an das Polymer chemisch gebunden ist und ausgewählt ist aus einer Verbindung, enthaltend aromatische Kohlenwasserstoffringe, eine substituierte oder unsubstituierte Phenylgruppe, eine substituierte oder unsubstituierte Anthracylgruppe, eine substituierte oder unsubstituierte Phenanthrylgruppe, eine substituierte oder unsubstituierte Naphthylgruppe, einen substituierten oder unsubstituierten heterocyclischen aromatischen Ring, enthaltend Heteroatome ausgewählt aus Sauerstoff, Stickstoff, Schwefel und Mischungen davon.

3. Zusammensetzung gemäß Anspruch 1 oder 2, wobei die Wiederholeinheit, enthaltend eine Hydroxyl- und/oder eine Carboxylgruppe, abgeleitet ist von einem Monomer ausgewählt aus Acrylsäure, Methacrylsäure, Vinylalkohol, Hydroxystyrolen, Copolymeren von Hydroxystyrol und Vinylmonomeren, enthaltend 1,1,1,3,3,3-Hexafluor-2-propanol.

4. Zusammensetzung gemäß einem der Ansprüche 1 bis 3, wobei die chromophore Gruppe und die Hydroxyl- und/oder Carboxylgruppe in der gleichen Wiederholeinheit zugegen sind.

5. Zusammensetzung gemäß einem der Ansprüche 1 bis 4, wobei das vinyletherterminierte Verzweigungsreagenz Tris(2-vinyloxyethyl)-1,3,5-cyclohexantricarboxylat ist.

6. Zusammensetzung gemäß einem der Ansprüche 1 bis 5, zusätzlich umfassend eine Säure oder einen thermischen Säuregenerator, wobei vorzugsweise die Säure oder die Säure, die von dem thermischen Säuregenerator abgeleitet ist, einen pKa von größer als 1,0 hat und wobei vorzugsweise die Säure oder die Säure, die von dem thermischen Säuregenerator abgeleitet ist, bei Temperaturen unter 220°C aus der Antireflexbeschichtung entfernt wird.

7. Zusammensetzung gemäß einem der Ansprüche 1 bis 6, zusätzlich umfassend einen Farbstoff, der vorzugsweise ausgewählt ist aus der Gruppe bestehend aus einem monomeren Farbstoff, einem polymeren Farbstoff und einer Mischung aus einem monomeren und einem polymeren Farbstoff.

8. Zusammensetzung gemäß einem der Ansprüche 1 bis 7, wobei die Antireflexbeschichtung einen k-Wert im Bereich von 0,1 bis 0,75 bei 193 nm aufweist.

9. Zusammensetzung gemäß einem der Ansprüche 1 bis 8, wobei das Polymer zusätzlich eine säurelabile Gruppe umfasst, die vorzugsweise ausgewählt ist aus tert-Butyl, tert-Pentyl, Isobornyl, 1-Alkylcyclohexyl, 1-Alkylcyclopentyl, Cyclohexyl, 2-Alkyl-2-adamantyl, 2-Alkyl-2-norbornyl, Tetrahydrofuranyl, Tetrahydropyranyl, substituiertem oder unsubstituiertem Methoxycarbonyl und b-Trialkylsilylalkyl.

10. Verfahren zur Ausbildung eines positiven Bildes, umfassend:
a) Ausbilden einer Beschichtung aus der photoabbildbaren Antireflexunterbeschichtungszusammensetzung gemäß einem der Ansprüche 1 bis 9 auf einem Substrat;
b) Erhitzen der Antireflexbeschichtung,
c) Aufbringen einer Beschichtung aus einer Photoresistoberschicht auf die Unterbeschichtung;
d) bildweises Belichten der Photoresist- und Unterbeschichtungsschichten durch aktinische Strahlung derselben Wellenlänge;
e) Erhitzen der Photoresist- und Unterbeschichtungsschichten auf dem Substrat nach der Belichtung; und
f) Entwickeln der Photoresist- und Unterbeschichtungsschichten mit einer wässrigen alkalischen Lösung.

11. Verfahren gemäß Anspruch 10, zusätzlich umfassend den Schritt der Entfernung von Edgebead nach der Beschichtung und vor dem Erhitzen der Antireflexbeschichtungszusammensetzung.

12. Verfahren gemäß Anspruch 10 oder 11, wobei die Antireflexbeschichtung nach dem Schritt des Erhitzens vor der Beschichtung der Photoresistsschicht in organischen Lösungsmitteln und wässriger alkalischer Lösung unlöslich wird und nach dem Belichten durch aktinische Strahlung vor dem Entwickeln der Photoresist- und der Antireflexunterbeschichtungsschicht in wässriger alkalischer Lösung löslich wird.

## Revendications

1. Composition de revêtement de fond antireflet photoimageable positive qui est susceptible d'être développée dans un révélateur alcalin aqueux, la composition de revêtement antireflet comprenant un polymère comprenant au moins un groupe chromophore, au moins un groupe labile en milieu acide et au moins un groupe hydroxyle et/ou carboxyle, un agent de réticulation à terminaison éther vinylique, et éventuellement un générateur de photoacide, l'agent de réticulation à terminaison éther vinylique étant choisi parmi le tricarboxylate de tris(2-vinyloxybutyl)-1,3,5-cyclohexane, le tricarboxylate de tris(2-vinyloxyéthyl)-1,3,5-cyclohexane, le tricarboxylate de tris(4-vinyloxybutyl)-1,2,4-cyclohexane et le tricarboxylate de tris(4-vinyloxyéthyl)-1,2,4-cyclohexane.

2. Composition selon la revendication 1, dans laquelle le groupe chromophore est lié chimiquement au polymère et est choisi parmi un composé contenant des cycles hydrocarbonés aromatiques, un groupe phényle substitué ou non substitué, un groupe anthracyle substitué ou non substitué, un groupe phénanthryle substitué ou non substitué, un groupe naphtyle substitué ou non substitué, des noyaux aromatiques hétérocycliques substitués ou non substitués contenant des hétéroatomes choisis parmi l'oxygène, l'azote et le soufre, et un mélange de ceux-ci.

3. Composition selon la revendication 1 ou 2, dans laquelle le motif récurrent contenant un groupe hydroxyle et/ou carboxyle est dérivé d'un monomère choisi parmi l'acide acrylique, l'acide méthacrylique, l'alcool vinylique, les hydroxystyrènes, les copolymères d'hydroxystyrène et les monomères vinyliques contenant du 1,1,1,3,3,3-hexafluoro-2-propanol.

4. Composition selon l'une quelconque des revendications 1 à 3, dans laquelle le groupe chromophore et le groupe hydroxyle et/ou carboxyle sont présents dans le même motif récurrent.

5. Composition selon l'une quelconque des revendications 1 à 4, dans laquelle l'agent de réticulation à terminaison éther vinylique est le tricarboxylate de tris(2-vinyloxyéthyl)-1,3,5-cyclohexane.

6. Composition selon l'une quelconque des revendications 1 à 5, comprenant en outre un acide ou un générateur d'acide thermique, l'acide ou l'acide dérivé du générateur d'acide thermique ayant de préférence un pKa supérieur à 1,0, et l'acide ou l'acide dérivé du générateur d'acide thermique étant de préférence retiré du revêtement antireflet à des températures inférieures à 220 °C.

7. Composition selon l'une quelconque des revendications 1 à 6, comprenant en outre un colorant, qui est de préférence choisi dans le groupe constitué par un colorant monomère, un colorant polymère et un mélange d'un colorant monomère et d'un colorant polymère.

8. Composition selon l'une quelconque des revendications 1 à 7, la composition antireflet ayant une valeur k dans la gamme de 0,1 à 0,75 à 193 nm.

9. Composition selon l'une quelconque des revendications 1 à 8, dans laquelle le polymère comprend en outre un groupe labile en milieu acide, qui est de préférence choisi parmi les groupes tert-butyle, tert-pentyle, isobornyle, 1-alkylcyclohexyle, 1-alkylcyclopentyle, cyclohexyle, 2-alkyl-2-adamantyle, 2-alkyl-2-norbornyle, tétrahydrofuranyle, tétrahydropyranyle, méthoxycarbonyle substitué ou non substitué et b-trialkylsilylalkyle.

10. Procédé de formation d'une image positive, comprenant :
a) la formation d'un revêtement de la composition de revêtement de fond antireflet photoimageable de l'une quelconque des revendications 1 à 9 sur un substrat ;
b) la cuisson du revêtement antireflet ;
c) le dépôt d'un revêtement d'une couche de résine photosensible supérieure par-dessus le revêtement de fond ;
d) l'exposition en forme d'image des couches de résine photosensible et de revêtement de fond à un rayonnement actinique de même longueur d'onde ;
e) la cuisson post-exposition des couches de résine photosensible et de revêtement de fond sur le substrat ; et
f) le développement des couches de résine photosensible et de revêtement de fond avec une solution alcaline aqueuse.

11. Procédé selon la revendication 10, comprenant en outre l'étape de retrait d'un bourrelet de bord après le revêtement et avant la cuisson de la composition de revêtement antireflet.

12. Procédé selon la revendication 10 ou 11, dans lequel le revêtement antireflet devient insoluble dans des solvants organiques et une solution alcaline aqueuse après l'étape de cuisson ayant le dépôt de la couche de résine photosensible, et devient soluble dans une solution alcaline aqueuse après l'exposition au rayonnement actinique avant le développement des couches de résine photosensible et de revêtement de fond antireflet.
